# EUROPEAN PATENT APPLICATION

(11) **EP 4 451 323 A2**
(43) Date of publication of application: **23.10.2024**
(21) Application number: 24198132.3
(22) Date of filing: 06.11.2023
(51) Int. Cl.: H01L 23/00

(54) **SIC-BASED ELECTRONIC DEVICE WITH MULTILAYER AND MULTIFUNCTIONAL PASSIVATION, AND METHOD OF MANUFACTURING THE ELECTRONIC DEVICE**

(30) Priority: 25.11.2022 IT 202200024396
(62) Divisional of application: 23207872.5
(71) Applicant: STMicroelectronics International N.V., 1228 Plan-les-Ouates, Geneva (CH)
(72) Inventor: BELLOCCHI, Gabriele, 95124 CATANIA (IT); RASCUNA', Simone, 95129 CATANIA (IT); PUGLISI, Valeria, 95125 CATANIA (IT)
(74) Representative: Studio Torta S.p.A.

(57) **Abstract**

Electronic device (50), comprising: a solid body (53, 58, 61) including a Silicon Carbide substrate, and further including an electrical terminal (58) of the electronic device on the substrate (53); a passivation layer (69) on the electrical terminal (58), of a first material; a first adhesion improving layer (82a) coupled to the passivation layer (69) and to the solid body (53), of a second material having predefined characteristics of adhesion to the first material, and configured to bond together the passivation layer (69) and the solid body (53); and a second adhesion improving layer (82b) between the solid body and the passivation layer (69) Columnar structures (92, 94) extend through the passivation layer (69) to physically couple the first adhesion improving layer (82a) to the second adhesion improving layer (82b).

## Description

The present invention relates to an electronic device and to a method of manufacturing the electronic device, in particular wherein a passivation layer of the electronic device is provided with one or more adhesion improving layers.

Silicon Carbide (SiC) is gaining considerable interest in the semiconductor industry, in particular for the manufacture of electronic components such as diodes or transistors, especially for power applications.

Electronic devices formed in a silicon carbide substrate, in its different polytypes (for example, 3C-SiC, 4H-SiC, 6H-SiC), have numerous advantages such as low output resistance in conduction, low leakage current, resistance at high operating temperatures and high operating frequencies.

However, the development and the manufacture of SiC-based electronic devices are limited by factors such as the electrical and mechanical properties of passivation layers (comprised in such electronic devices and, for example, extending on SiC semiconductor bodies of electronic devices). In particular, it is known to form the passivation layers using polymeric materials (e.g., polyimide) which allow to withstand high operating temperatures of the electronic devices and have high dielectric strength, for example higher than 400 kV/mm. In detail, the high dielectric strength of polymeric materials ensures that the passivation layers withstand high electric fields, and therefore high potential differences thereacross, without breaking or perforating ("electrical breakdown"), and therefore without becoming electrically conductive.

However, polymeric materials have high coefficients of thermal expansion (CTE) (e.g., CTE=43e⁻⁶ 1/K for Polybenzobisoxazole material, or "PIX"), and it causes adhesion problems of the passivation layer to SiC, which has a lower coefficient of thermal expansion (CTE=3.8e-6 1/K).

In particular, such adhesion problems between the passivation layer and the SiC may arise during thermal cycling tests (performed for example between about -50°C and about +150°C) or during use of the electronic device, when the latter is subject to high thermal excursions (e.g., it is subject to operating temperature differences equal to, or greater than, about 200°C). Due to the high difference in CTE between the passivation layer and the SiC, such high thermal excursions generate mechanical stresses at an interface between the passivation layer and the SiC, which may lead to a(n) (at least partial) delamination of the passivation layer with respect to the SiC semiconductor body.

If this delamination were sufficiently extended (e.g., it were such that no portion of the passivation layer is interposed between two metallizations of the electronic device set at different potentials, which are therefore separated from each other only by air), electric discharges may generate at said interface, leading to the damage of the same electronic device. In particular, the risk of damaging the electronic device increases when the latter is used in reverse bias conditions, due to the high voltage difference (e.g., greater than 1000 V) to withstand.

Known solutions to this problem comprise the use of a plurality of dielectric layers of materials different from each other (e.g., Silicon Nitride, Silicon oxide and polyamide in succession to each other) to form a passivation multi-layer for limiting the mechanical stresses at the interface with the SiC semiconductor body.

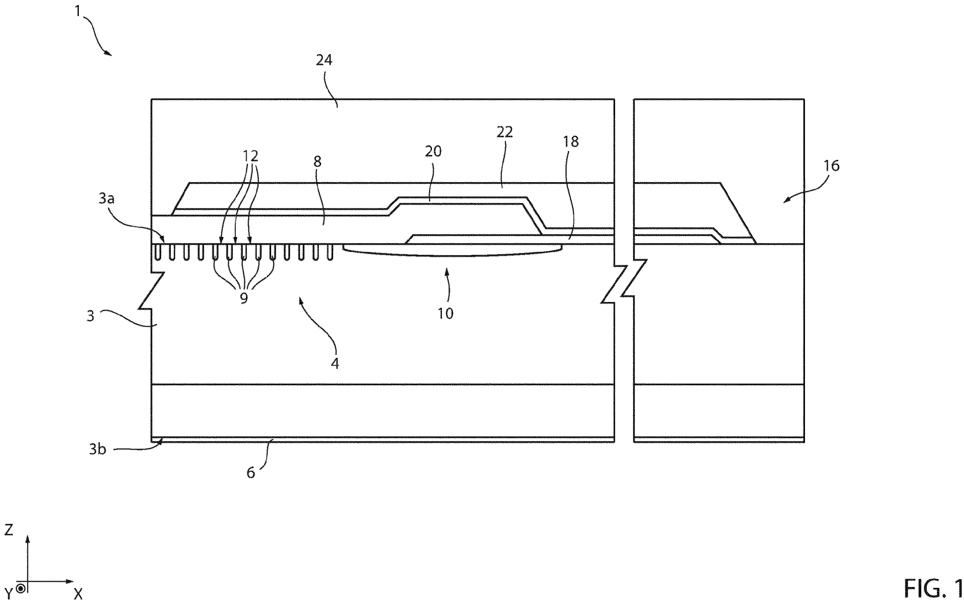

Figure 1 shows, in lateral sectional view in a Cartesian (triaxial) reference system of axes X, Y, Z, a portion of an electronic device (here exemplarily a JBS, "Junction Barrier Schottky", diode) 1 of a known type.

The JBS device 1 comprises a semiconductor body 3, of N-type SiC, provided with a surface 3a opposite to a surface 3b. The semiconductor body includes, for example, a substrate and one or more regions epitaxially grown on the substrate, of the N-type and having respective doping concentration values. The JBS device 1 also comprises multiple junction-barrier (JB) elements 9 in the semiconductor body 3, facing the top surface 3a and each including a respective region implanted in the semiconductor body 3, of the P-type, and an ohmic contact on the implanted region, at the level of the top surface 3a of the semiconductor body 3. The JBS device 1 further comprises a first metallization 8, which extends on the top surface 3a, in electrical contact with the junction-barrier elements 9 through the respective ohmic contacts. The JBS device 1 further comprises an edge termination region 10 (or guard ring), in particular a P-type implanted region, which completely surrounds the JB elements 9.

Schottky diodes 12 are formed at the interface between the anode metallization 8 and the semiconductor body 3, where semiconductor-metal Schottky junctions are formed. The region of the MPS device 1 which includes the JB elements 9 and the Schottky diodes 12 (i.e., the region contained within the guard ring 10) is an active area 4 of the JBS device 1.

The JBS device 1 further comprises a second metallization 6, which extends on the bottom surface 3b. The first and the second metallizations 8, 6 form, respectively, anode and cathode electrical terminals, biasable during use of the JBS device 1.

An electrically passive region 16 extends outside the edge termination region 10.

An insulating layer 18, of insulating or dielectric material, in particular Silicon Oxide (SiO₂), extends partially above the edge termination region 10.

The first metallization 8 is in electrical contact with a portion of the edge termination region 10 where the latter is not covered by the insulating layer 18, and also extends partially above the insulating layer 18. An interface layer 20, here of Silicon Nitride (SiN), extends above the first metallization 8 and the insulating layer 18. Furthermore, the JBS device 1 comprises a passivation layer 22, in particular of polyimide, which extends above the interface layer 20. In other words, the interface layer 20 acts as an interface between the passivation layer 22 and the underlying layers, here the first metallization 8 and the insulating layer 18. The interface layer 20 may be omitted; however, the Applicant has verified that the interface layer 20 improves the adhesion of the passivation layer 22 with the underlying layers.

A protection layer 24, of a resin such as for example Bakelite, extends above the passivation layer 22, to protect the JBS device 1 when inserted in a package (not shown).

However, although the interface layer 20 improves, as said, the adhesion of the passivation layer 22 with the underlying layers, some critical conditions of use or of thermal or thermo-mechanical test of the JBS device 1 may cause a delamination or partial detachment of the passivation layer 22 from the interface layer 20 (due to the stress generated by the tests). This occurs in particular under conditions of stress caused by high use temperatures (e.g., above 150°C) and/or high thermal excursion (e.g., higher than 200°C). This effect, in addition to making the JBS 1 device structurally fragile, may be a contributing factor in the occurrence of undesired electric discharges which affect the electrical operation of the JBS 1 device. In fact, the Applicant has verified that in some conditions of thermo-mechanical or mechanical stress process following the assembling process, the interface layer 20 has one or more local cracks throughout the entire thickness which, at the first metal layer 8, cause the generation of such electric discharges. These problems are all the more evident when the electronic device 1 is subject to high thermal excursions and high voltage differences under reverse bias conditions.

The need to overcome the aforementioned problems is therefore felt.

According to the present invention, an electronic device and a method of manufacturing the electronic device are provided, as defined in the attached claims.

For a better understanding of the present invention, a preferred embodiment is now described, purely by way of non-limiting example, with reference to the attached drawings, wherein:
- Figure 1 illustrates, in a cross-sectional view, an electronic device of known type; and
- Figures 2-5 and 7-8 illustrate, in cross-sectional view, respective electronic devices according to respective embodiments of the present disclosure;
- Figure 6 illustrate, in cross-sectional view, an electronic device according to an embodiment of the present invention.

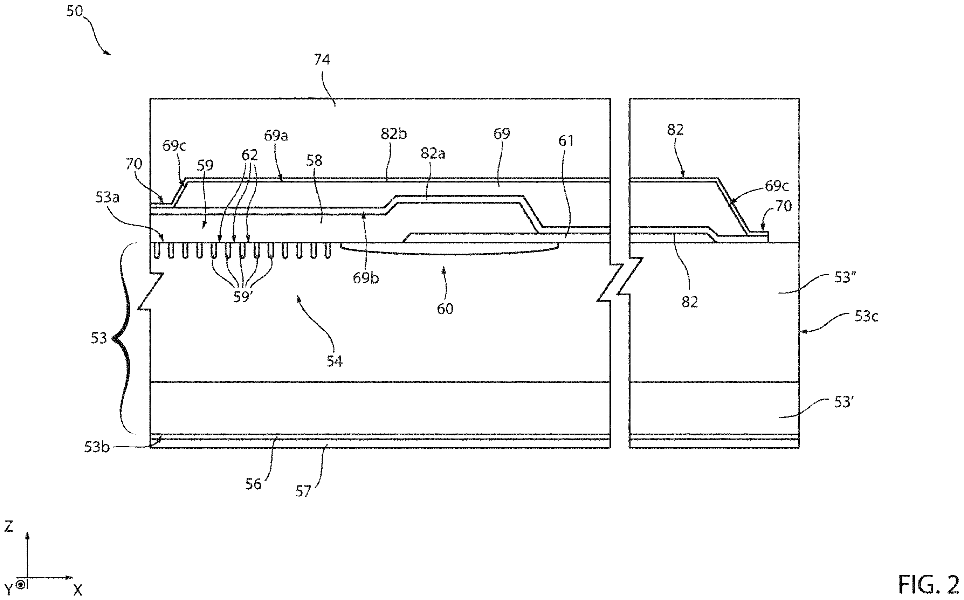

Figure 2 shows, in lateral-sectional view in the same Cartesian (triaxial) reference system of axes X, Y, Z, of Figure 1, an electronic device 50 according to an aspect of the present disclosure. In particular, the device 50 is a JBS diode, in analogy to what has been described with reference to Figure 1; however, the present disclosure is not limited to this device and also finds application to other types of electronic devices, in particular power devices, such as for example MOSFET, IGBT, MPS, Schottky diode, PN diode, PiN diode, etc.

The electronic device 50 comprises the elements described hereinbelow, illustrated with reference to Figure 2.

A semiconductor body 53 (e.g., including a substrate 53' and, optionally, one or more epitaxial layers 53" grown thereon), of N-type or P-type SiC (hereinafter non-limiting reference will be made to the sole N-type), is provided with a front surface 53a opposite to a rear surface 53b along the direction of the Z axis. The semiconductor body 53 includes, in the example illustrated in Figure 2, the substrate 53' having the epitaxial layer 53" grown thereon acting as a drift layer of the electronic device 50, both of N-type SiC (in particular 4H-SiC, however other polytypes may be used such as, but not limited to, 2H-SiC, 3C-SiC and 6H-SiC). For example, the substrate 53' has an N-type dopant concentration comprised between 1·10¹⁹ at/cm³ and 1·10²² at/cm³ and has a thickness, measured along the Z axis between the surfaces 53a and 53b, comprised between 300 pm and 450 pm, and in particular equal to about 360 µm. The drift layer 53" has a respective dopant concentration lower than the dopant concentration of the substrate and a thickness comprised, for example, between 5 and 15 pm.

An ohmic contact layer 56 (for example of Nickel Silicide) extends on the rear surface 53b, and a metallization 57, in this example a cathode metallization, for example of Ti/NiV/Ag or Ti/NiV/Au, extends on the ohmic contact region 56.

One or more P-type doped regions 59' extend in the semiconductor body 53 (in particular in the drift layer), facing the top surface 53a; each doped region 59' houses a respective ohmic contact (not shown and of known type) such that each doped region 59' forms a respective Junction-Barrier (JB) element 59. An edge termination region, or guard ring, 60, in particular a further P-type doped region, extends in the drift layer, faces the top surface 53a and completely surrounds (in plan view, on an XY plane defined by the axes X and Y) the JB elements 59. The edge termination region 60 may be omitted.

An insulating layer 61 (of insulating or dielectric material, e.g. Silicon Oxide, TEOS) extends on the top surface 53a in such a way as to completely surround (in view on the XY plane) the JB elements 59 and to be partially superimposed on the guard ring 60 (when present).

A metallization 58, in this example an anode metallization, for example of Ti/AlSiCu or Ni/AlSiCu, extends on a portion of the top surface 53a delimited externally by the insulating layer 61 (i.e., at the JB elements 59 / active area 54) and, partially, on the insulating layer 61.

A passivation layer 69 of polymeric material such as polyimide (e.g., PIX) extends on the anode metallization 58 and on the insulating layer 61.

The passivation layer 69 may alternatively be of a material from among: HfO₂, ZrO₂, TiO₂, Ta₂O₅, TiN, ZnO, AZO, GZO.

The passivation layer 69 is delimited by a top side 69a, a bottom side 69b, opposite to the top side 69a along the direction of the Z axis, and by lateral portions 69c which connect the top side 69a to the bottom side 69b.

One or more Schottky diodes 62 are formed at the interface between the semiconductor body 53 and the anode metallization 58, laterally to the doped regions 59'. In particular, Schottky junctions (semiconductor-metal) are formed by portions of the semiconductor layer 53 in direct electrical contact with respective portions of the anode metallization 58.

Furthermore, each ohmic contact extending in the respective doped region 59' provides an electrical connection having an electrical resistivity value lower than the electrical resistivity value of the doped region 59' housing it. The JB elements 59 are therefore P-i-N diodes.

The region of the electronic device 50 which includes the JB elements 59 and the Schottky diodes 62 (i.e., the region delimited by the guard ring 60) is an active area 54 of the electronic device 50.

Outside the active area 54, i.e. beyond the edge termination region 60, a lateral surface 53c of the semiconductor body 53 is present, for example extending substantially orthogonally to the top surface 53a. The lateral surface 53c is formed following a dicing, or singulation, step of a SiC wafer wherein a plurality of electronic devices 50 are provided. The dicing step has the function of separating an electronic device 50 from another device 50 of the same wafer. The dicing occurs at a scribe line (not shown) of the SiC wafer wherefrom the electronic device 50 is obtained; this scribe line surrounds at a distance, on the XY plane, the active region 54, the guard ring 60 and the insulating layer 61.

A protection layer 74, of a resin such as for example Bakelite, extends above the passivation layer 69, to protect the electronic device 50 when inserted in a package (not shown).

According to one aspect, the passivation layer 69 is at least in part covered by an encapsulation structure 82 which extends below the passivation layer 69 and above the passivation layer 69. The encapsulation structure has the function of improving the adhesion of the passivation layer 69 to the rest of the electronic device 50 and therefore hereinafter it, and the layers forming it, will also be referred to as "adhesion improving structure", or "adhesion improving layers", respectively.

The encapsulation structure 82 comprises, in particular, a first portion 82a (first encapsulation layer or first adhesion improving layer) extending above the anode metallization 58 and the insulating layer 61 (in particular, in direct contact with the anode metallization 58 and the insulating layer 61), and below the passivation layer 69 (in particular, in direct contact with the passivation layer 69). In other words, the first encapsulation layer 82a acts as an interface between the passivation layer 69 and the underlying layers, herein the metallization 58 and the insulating layer 61.

In one embodiment (Figure 2) the first encapsulation layer 82a extends throughout the entire extension of the bottom side 69b of the passivation layer 69; in particular, the first encapsulation layer 82a has a greater extension than the corresponding extension of the bottom side 69b of the passivation layer 69 (i.e., the first encapsulation layer 82a extends beyond the lateral portions 69c).

The encapsulation structure 82 further comprises a second portion 82b (second encapsulation layer or second adhesion improving layer) extending on the top side 69a of the passivation layer 69 and on the lateral portions 69c, up to reaching and contacting the first encapsulation layer 82a wherein the first encapsulation layer protrudes beyond the lateral portions 69c. In this manner, contact regions 70 between the first and the second encapsulation layers 82a, 82b provide a physical coupling element between the first and the second encapsulation layers 82a, 82b, configured to bond the second encapsulation layer 82b to the first encapsulation layer 82a, thus obviating a possible detachment of the passivation layer 69.

The first and the second encapsulation layers 82a, 82b do not extend at the regions dedicated to housing the scribe line.

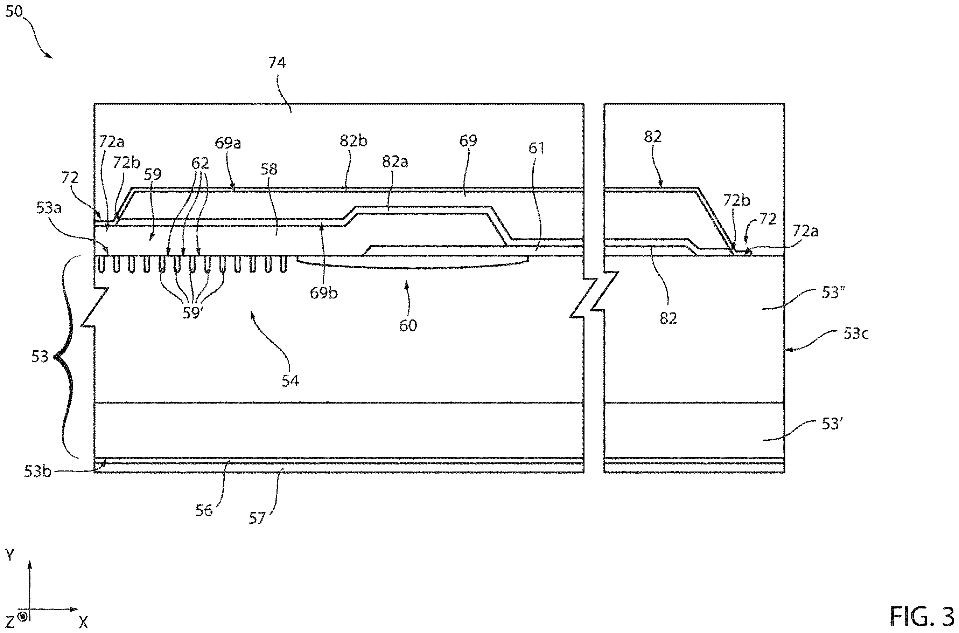

In a further embodiment, illustrated in Figure 3 (elements common to those of Figure 2 are identified with the same reference numerals and are not further described), the first encapsulation layer 82a extends throughout the entire extension of the bottom side 69b of the passivation layer 69 and, in particular, has an extension equal to the corresponding extension of the bottom side 69b of the passivation layer 69 (i.e., the first encapsulation layer 82a does not extend beyond the lateral portions 69c). The second encapsulation layer 82b extends, as well as on the passivation layer 69, also on the top surface 53a of the semiconductor body 53 on the right side of the representation of Figure 3, and on the metallization 58 on the left side of the representation of Figure 3, forming respective coupling regions 72. The coupling regions 72 comprise a respective contact portion 72a between the second encapsulation layer 82b and the underlying layers (top surface of the substrate 53c / metallization 58), and a respective lateral contact portion 72b between the second encapsulation layer 82b and the first encapsulation layer 82a. In this manner, the passivation layer 69 is encapsulated, thus obviating a possible detachment of the passivation layer 69.

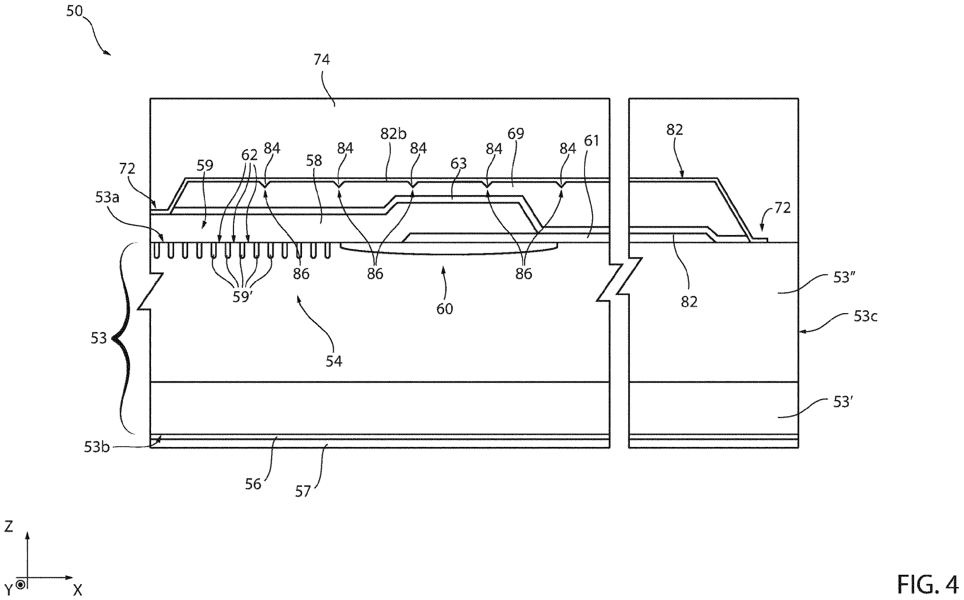

The aspects discussed hereinbelow apply to all embodiments of the present disclosure, in particular to those of Figures 2 and 3 described above and to those of Figures 4-6 described below.

According to one aspect, the encapsulation structure 82 extends around the passivation layer 69 without interruptions (seamlessly) and without interfaces; in this case, both the first and the second encapsulation layers 82a, 82b are of a same material. In this embodiment, at the end of the manufacturing steps, the first and the second encapsulation layers 82a, 82b form a single body.

In a further aspect, the first and the second encapsulation layers 82a, 82b are of respective materials different from each other.

In general, the materials of the first and the second encapsulation layers 82a, 82b are configured to have predetermined characteristics of adhesion to the material of the passivation layer 69 and to the underlying layers (here, the layers 58 and 61), in order to prevent delaminations and/or detachments of the passivation layer 69. The first and the second encapsulation layers 82a, 82b also act as protection for the passivation layer 69 to prevent cracks of the same.

Materials for the aforementioned purposes include aluminum oxide (or alumina) Al₂O₃ and hafnium oxide Hf₂O₃, in particular in case the passivation layer 69 is of a material from among polyimide, HfO₂, ZrO₂, TiO₂, Ta₂O₅, TiN, ZnO, AZO, GZO.

The Applicant has verified that a deposition by ALD (Atomic Layer Deposition) technique is effective in forming encapsulation layers 82a, 82b with characteristics of adhesion and protection suitable for the purposes of the present disclosure. The encapsulation layers 82a, 82b have, for example, a thickness comprised between 8 nm and 100 nm, in particular between 10 nm and 50 nm.

In one aspect, the first and the second encapsulation layers 82a, 82b are both of Al₂O₃.

In a further aspect, the first and the second encapsulation layers 82a, 82b are both of Hf₂O₃.

In a further aspect, the first encapsulation layer 82a is of Al₂O₃ and the second encapsulation layer 82b is of Hf₂O₃.

In a further aspect, the first encapsulation layer 82a is of Hf₂O₃ and the second encapsulation layer 82b is of Al₂O₃.

It is evident that other materials having characteristics of adhesion to the passivation layer 69 may be chosen according to the material used for the passivation layer 69.

In addition to the aforementioned characteristics of adhesion, the Applicant has verified that Hf₂O₃ and Al₂O₃ possess humidity barrier properties.

Figure 4 illustrates a further embodiment. Elements common to Figures 2 and 3 are illustrated with the same reference numerals and are not further described. It should be noted that, although Figure 4 illustrates coupling regions 72 of the type illustrated in Figure 3, the embodiment of Figure 4 is not limited to this aspect. In fact, coupling regions of the type illustrated in Figure 2 with the reference numeral 70 may equally apply to the embodiment of Figure 4.

In the embodiment illustrated in Figure 4, one or more anchor elements 84 are formed between the second encapsulation layer 82b and the passivation layer 69. Referring to Figure 4, each anchor element 84 extends through an opening or indentation 86 formed through the passivation layer 69. The opening 86 has a shape freely chosen during the design step, for example a circular, oval, generically polygonal, or irregular shape.

Each anchor element 84 follows the shape of the opening 86 and is for further improving the bonding (adhesion) of the second encapsulation layer 82b to the passivation layer 69. The cavity 86 which houses the respective anchor element 84 therefore has a complementary shape with respect to the shape of the anchor element 84. In other words, each anchor element 84 completely fills the cavity housing it.

Each anchor element 84 is of the same material as the second encapsulation layer 82b and therefore forms a single body, or monolithic structure, with the second encapsulation layer 82b. Each anchor element 84 is formed simultaneously with the second encapsulation layer 82b, for example during the step of forming (depositing) the material of the second encapsulation layer 82b.

The openings 86 may be replaced by a general roughness or granularity of the top surface of the passivation layer 69.

As previously said, the Applicant has verified that characteristics of adhesion for the purpose of the present disclosure may be obtained, in one embodiment, by ALD deposition of the second encapsulation layer 82b; however, in the case of Figure 4, other types of deposition may be used, for example CVD deposition, since the presence of the anchor elements 84 is per se sufficient to obtain the aforementioned characteristics of adhesion.

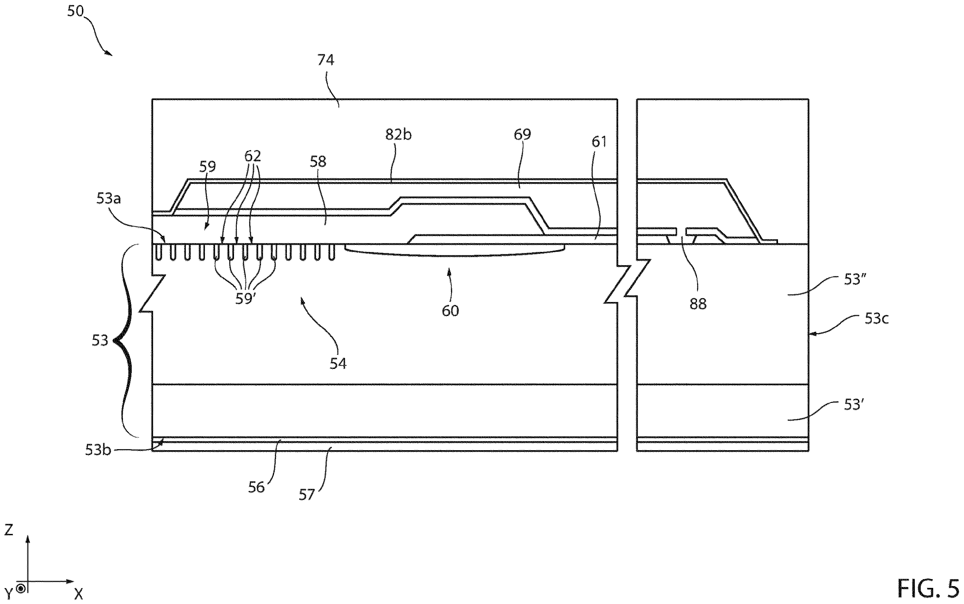

Figure 5 (elements common to Figures 2-4 have the same reference numerals and are not further described) illustrates a further embodiment, wherein a physical anchor 88 is formed between the passivation layer 69 and the semiconductor body 53. The anchor 88 of Figure 5 may apply to any of the previously described embodiments. The anchor element 88 protrudes from the passivation layer 69 (in particular, along the direction of the Z axis) and extends, through the first encapsulation layer 82a, inside the insulating layer 61, up to reaching the top surface 53a of the semiconductor body 53. The anchor element 88 anchors and bonds the passivation layer 69 to the insulating layer 61. The anchor element 88 is integral with the passivation layer 69 and, in particular, is an extension of the same passivation layer 69. The anchor element 88 therefore extends from the passivation layer 69 without interruptions (seamlessly) and without interfaces and is of the same material as the passivation layer 69. In other words, the anchor element 88 and the passivation layer 69 form a single, or monolithic, body. The anchor element 82 extends in, and fills, a through hole formed through the encapsulation layer 82a. This through hole has a shape freely chosen during the design step, for example a circular, oval or polygonal shape, with a diameter along the X axis equal to a few micrometers, for example between 2 and 5 pm. The anchor element 88 is formed outside the active area 54, and in particular outside the edge termination region 60; in other words, the anchor element 88 is interposed between the edge termination region 60 and the lateral surface 53c. In the event that the edge termination region 60 is not present, the anchor element 88 is formed outside the active area 54, i.e. between the active area 54 and the lateral surface 53c in an electrically passive region of the device. The anchor element 88 is patterned in such a way as to bond the passivation layer 69 to the insulating layer 61 and is for further improving the adhesion of the passivation layer 69, preventing and/or avoiding the delamination and/or the detachment of the passivation layer 69. In particular, the anchor element 88 is housed and fit into a housing or cavity extending in the insulating layer 61, in such a way as to couple and make the passivation layer 69 and the insulating layer 61 integral with each other. The cavity which houses the anchor element 88 has a complementary shape with respect to the shape of the anchor element 88. In other words, the anchor element 88 completely fills the cavity housing it.

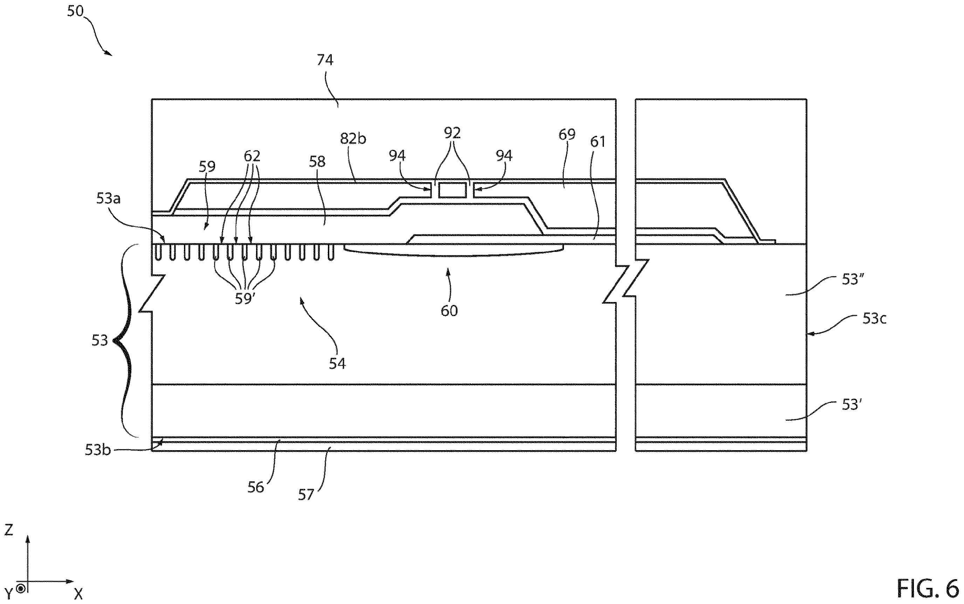

Figure 6 (features in common with Figures 2-5 have the same reference numerals and are not further described) illustrates an embodiment of the present invention, wherein one or more anchor elements 92 extend in respective one or more trenches 94 which traverse the passivation layer 69 throughout the entire thickness along the Z axis. In this embodiment, the anchor elements 92 connect the first encapsulation layer 82a to the second encapsulation layer 82b.

In this embodiment, the trenches 94 are formed by steps of etching the passivation layer 69 and then the anchor elements 92 are formed by filling these trenches 94 during the step of forming the second encapsulation layer 82b and with the same material used to form the second encapsulation layer 82b. If allowed by the extension along the Z axis of the trenches 94, the anchor elements 92 and the second encapsulation layer 82b are formed simultaneously by ALD deposition; alternatively, a CVD deposition may be used to fill the trenches 94, forming the anchor elements 92, and to form simultaneously the second encapsulation layer 82b.

According to a non-limiting aspect of this embodiment, since the thickness of the passivation layer 69 might not be (typically, is not) uniform along the entire extension of the same, such trenches 94 and relative anchor elements 92 may be formed at the thinner portions (along the Z axis) of the passivation layer 69.

Anchor elements of the type illustrated in Figure 6 may also be implemented in any of the embodiments previously described, in a per se evident manner.

According to a further embodiment of the invention, which is based on the embodiment of Figure 6 (elements common with Figure 6 have the same reference numerals and are not further described), the connection regions 70 or 72 (better described in of Figures 2 or 3, respectively) are omitted. In other words, the second encapsulation layer does not extend on the lateral walls 69c of the passivation layer 69, or it extends only in part on the lateral walls 69c.

The anchor elements 92 between the first and the second encapsulation layers 82a, 82b provide respective physical coupling elements between the first and the second encapsulation layers 82a, 82b, configured to bond the second encapsulation layer 82b to the first encapsulation layer 82a, encapsulating the passivation layer 69 and thus obviating a possible detachment of the passivation layer 69.

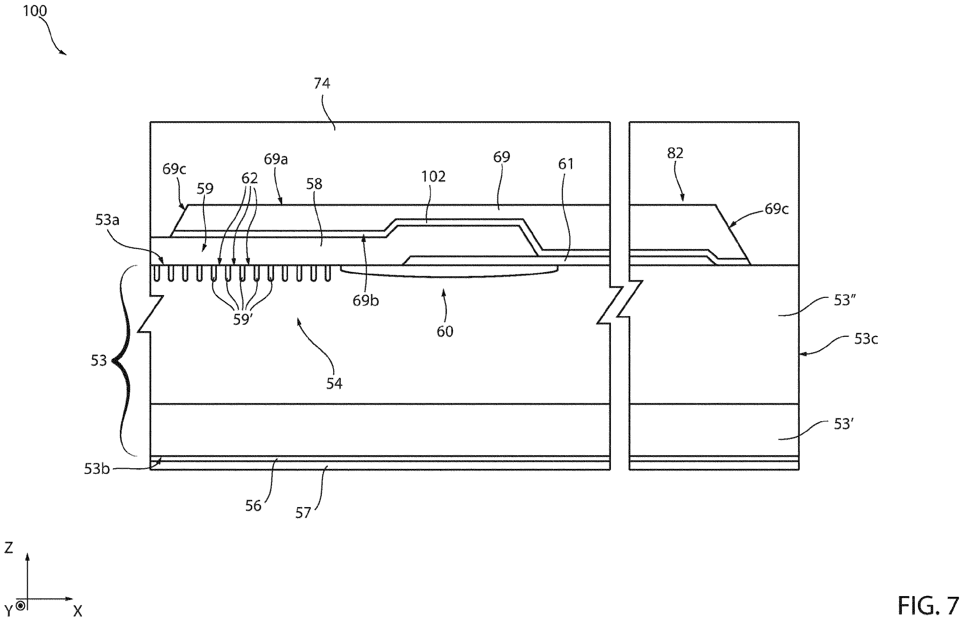

Figure 7 shows a further embodiment of an electronic device 100, according to a further aspect of the present disclosure.

Figure 7 shows, in lateral sectional view in the same Cartesian (triaxial) reference system of axes X, Y, Z, of Figures 1-6, the electronic device 100. In particular, the device 100 is a JBS diode, in analogy to what has been described with reference to Figures 1-6; however, the embodiment of Figure 7 is not limited to this JBS device and also finds application to other types of electronic devices, in particular power devices, such as for example MOSFET, IGBT, MPS, Schottky diode, PN diode, PiN diode, etc.

The electronic device 100 comprises the elements described hereinafter, wherein elements common to the embodiments of Figures 2-6 are identified with the same reference numerals.

A semiconductor body 53 (e.g., including a substrate 53' and, optionally, one or more epitaxial layers 53" grown thereon), of N-type or P-type SiC (hereinafter non-limiting reference will be made to the sole N-type), is provided with a front surface 53a opposite to a rear surface 53b along the direction of the Z axis. The semiconductor body 53 includes the substrate 53' having the epitaxial layer 53" grown thereon acting as a drift layer of the electronic device 100, both of N-type SiC (in particular 4H-SiC, however other polytypes may be used such as, but not limited to, 2H-SiC, 3C-SiC and 6H-SiC). For example, the substrate 53' has an N-type dopant concentration comprised between 1·10¹⁹ at/cm³ and 1·10²² at/cm³ and has a thickness, measured along the Z axis between the surfaces 53a and 53b, comprised between 300 pm and 450 pm, and in particular equal to about 360 µm. The drift layer 53" has a respective dopant concentration lower than the dopant concentration of the substrate and a thickness comprised, for example, between 5 and 15 pm.

An ohmic contact layer 56 (for example of Nickel Silicide) extends on the rear surface 53b, and a metallization 57, in this example a cathode metallization, for example of Ti/NiV/Ag or Ti/NiV/Au, extends on the ohmic contact region 56.

One or more P-type doped regions 59' extend in the semiconductor body 53 (in particular in the drift layer), facing the top surface 53a; each doped region 59' houses a respective ohmic contact (not shown and of known type) such that each doped region 59' forms a respective Junction-Barrier (JB) element 59. An edge termination region, o guard ring, 60, in particular a further P-type doped region, extends in the drift layer, faces the top surface 53a and completely surrounds (in plan view, on an XY plane defined by the axes X and Y) the JB elements 59. The edge termination region 60 may be omitted.

An insulating layer 61 (of insulating or dielectric material, e.g. Silicon Oxide, TEOS) extends on the top surface 53a in such a way as to completely surround (in view on the XY plane) the JB elements 59 and to be partially superimposed on the guard ring 60 (when present).

A metallization 58, in this example an anode metallization, for example of Ti/AlSiCu or Ni/AlSiCu, extends on a portion of the top surface 53a delimited externally by the insulating layer 61 (i.e., at the JB elements 59 / active area 54) and, partially, on the insulating layer 61.

A passivation layer 69 of polymeric material such as polyimide (e.g., PIX), extends on the anode metallization 58 and on the insulating layer 61. The passivation layer 69 is delimited by a top side 69a, a bottom side 69b, opposite to the top side 69a along the Z axis direction, and by lateral portions 69c connecting the top side 69a to the bottom side 69b.

One or more Schottky diodes 62 are formed at the interface between the semiconductor body 53 and the anode metallization 58, laterally to the doped regions 59'. In particular, Schottky junctions (semiconductor-metal) are formed by portions of the semiconductor layer 53 in direct electrical contact with respective portions of the anode metallization 58.

Furthermore, each ohmic contact extending in the respective doped region 59' provides an electrical connection having an electrical resistivity value lower than the electrical resistivity value of the doped region 59' housing it. The JB elements 59 are therefore P-i-N diodes.

The region of the electronic device 100 that includes the JB elements 59 and the Schottky diodes 62 (i.e., the region delimited by the guard ring 60) is an active area 54 of the electronic device 100.

Outside the active area 54, i.e. beyond the edge termination region 60, a lateral surface 53c of the semiconductor body 53 is present, for example extending substantially orthogonally to the top surface 53a. The lateral surface 53c is formed following a dicing, or singulation, step of a SiC wafer wherein a plurality of electronic devices 100 are provided. The dicing step has the function of separating an electronic device 100 from another device 100 of the same wafer. The dicing occurs at a scribe line (not shown) of the SiC wafer wherefrom the electronic device 100 is obtained; this scribe line surrounds at a distance, on the XY plane, the active region 54, the guard ring 60 and the insulating layer 61.

A protection layer 74, of a resin such as for example Bakelite, extends above the passivation layer 69, to protect the electronic device 50 when inserted in a package (not shown).

According to one aspect, an interface layer 102 extends continuously between the passivation layer 69 and the underlying metallization 58 and insulating layers 61. In particular, the interface layer 102 is in direct contact with the anode metallization 58 and the insulating layer 61 on one side, and with the passivation layer 69 on the opposite side.

The interface layer 102 extends at least throughout the entire extension of the bottom side 69b of the passivation layer 69. The interface layer 102 does not extend at the regions dedicated to housing the scribe line.

According to one aspect, the interface layer 102 is of a material configured to have predetermined characteristics of adhesion to the material of the passivation layer 69 and to the layers 58 and 61, in order to prevent delaminations and/or detachments of the passivation layer 69. Materials for this purpose include aluminum oxide (or alumina) Al₂O₃ and hafnium oxide Hf₂O₃. The Applicant has verified that a deposition by ALD (Atomic Layer Deposition) technique is effective in forming encapsulation layers 82a, 82b with characteristics of adhesion and protection suitable for the purposes of the present disclosure. The interface layer 102 has, for example, a thickness comprised between 8 nm and 100 nm, in particular between 10 nm and 50 nm. In addition to the aforementioned characteristics of adhesion, the Applicant has verified that the interface layer 102 of Hf₂O₃ or Al₂O₃ possesses humidity barrier properties.

An anchor element 88, as described with reference to Figure 5, may be implemented in the embodiment of Figure 7, in a per se evident manner and therefore not further described.

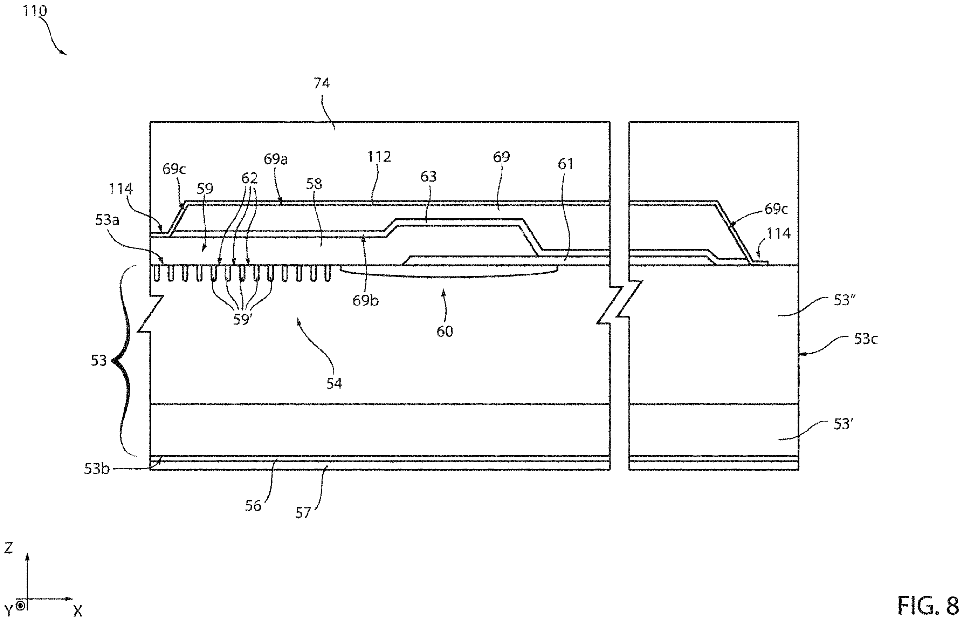

Figure 8 shows a further embodiment of an electronic device 110, according to a further aspect of the present disclosure.

Figure 8 shows, in lateral sectional view in the same Cartesian (triaxial) reference system of axes X, Y, Z, of Figures 1-7, the electronic device 110. In particular, the device 110 is a JBS diode, in analogy to what has been described with reference to Figures 1-7; however, the embodiment of Figure 8 is not limited to this JBS device and also finds application to other types of electronic devices, in particular power devices, such as for example MOSFET, IGBT, MPS, Schottky diode, PN diode, PiN diode, etc.

The electronic device 110 comprises the elements described hereinafter, wherein elements common to the embodiments of Figures 2-6 are identified with the same reference numerals.

A semiconductor body 53 (e.g., including a substrate 53' and, optionally, one or more epitaxial layers 53" grown thereon), of N-type or P-type SiC (hereinafter non-limiting reference will be made to the sole N-type), is provided with a front surface 53a opposite to a rear surface 53b along the direction of the Z axis. The semiconductor body 53 includes the substrate 53' having the epitaxial layer 53" grown thereon acting as a drift layer of the electronic device 110, both of N-type SiC (in particular 4H-SiC, however other polytypes may be used such as, but not limited to, 2H-SiC, 3C-SiC and 6H-SiC). For example, the substrate 53' has an N-type dopant concentration comprised between 1·10¹⁹ at/cm³ and 1·10²² at/cm³ and has a thickness, measured along the Z axis between the surfaces 53a and 53b, comprised between 300 µm and 450 pm, and in particular equal to about 360 µm. The drift layer 53" has a respective dopant concentration lower than the dopant concentration of the substrate and a thickness comprised, for example, between 5 and 15 pm.

An ohmic contact layer 56 (for example of Nickel Silicide) extends on the rear surface 53b, and a metallization 57, in this example a cathode metallization, for example of Ti/NiV/Ag or Ti/NiV/Au, extends on the ohmic contact region 56.

One or more P-type doped regions 59' extend in the semiconductor body 53 (in particular in the drift layer), facing the top surface 53a; each doped region 59' houses a respective ohmic contact (not shown and of known type) such that each doped region 59' forms a respective Junction-Barrier (JB) element 59. An edge termination region, o guard ring, 60, in particular a further P-type doped region, extends in the drift layer, faces the top surface 53a and completely surrounds (in plan view, on an XY plane defined by the axes X and Y) the JB elements 59. The edge termination region 60 may be omitted.

An insulating layer 61 (of insulating or dielectric material, e.g. Silicon Oxide, TEOS) extends on the top surface 53a in such a way as to completely surround (in view on the XY plane) the JB elements 59 and to be partially superimposed on the guard ring 60 (when present).

A metallization 58, in this example an anode metallization, for example of Ti/AlSiCu or Ni/AlSiCu, extends on a portion of the top surface 53a delimited externally by the insulating layer 61 (i.e., at the JB elements 59 / active area 54) and, partially, on the insulating layer 61.

A passivation layer 69 of polymeric material such as polyimide (e.g., PIX), extends on the anode metallization 58 and on the insulating layer 61. The passivation layer 69 is delimited by a top side 69a, a bottom side 69b, opposite to the top side 69a along the Z axis direction, and by lateral portions 69c connecting the top side 69a to the bottom side 69b.

An interface layer 63, here of Silicon Nitride (SiN), extends above the anode metallization 58 and the insulating layer 61, and below the passivation layer 69. In other words, the interface layer 63 acts as an interface between the passivation layer 69 and the underlying layers, here the metallization 58 and the insulating layer 61 and allows the adhesion of the overlying passivation layer 69.

One or more Schottky diodes 62 are formed at the interface between the semiconductor body 53 and the anode metallization 58, laterally to the doped regions 59'. In particular, Schottky junctions (semiconductor-metal) are formed by portions of the semiconductor layer 53 in direct electrical contact with respective portions of the anode metallization 58.

Furthermore, each ohmic contact extending in the respective doped region 59' provides an electrical connection having an electrical resistivity value lower than the electrical resistivity value of the doped region 59' housing it. The JB elements 59 are therefore P-i-N diodes.

The region of the electronic device 100 that includes the JB elements 59 and the Schottky diodes 62 (i.e., the region delimited by the guard ring 60) is an active area 54 of the electronic device 110.

Outside the active area 54, i.e. beyond the edge termination region 60, a lateral surface 53c of the semiconductor body 53 is present, for example extending substantially orthogonally to the top surface 53a. The lateral surface 53c is formed following a dicing, or singulation, step of a SiC wafer wherein a plurality of electronic devices 110 are provided. The dicing step has the function of separating an electronic device 110 from another device 110 of the same wafer. The dicing occurs at a scribe line (not shown) of the SiC wafer wherefrom the electronic device 110 is obtained; this scribe line surrounds at a distance, on the XY plane, the active region 54, the guard ring 60 and the insulating layer 61.

A protection layer 74, of a resin such as for example Bakelite, extends above the passivation layer 69, to protect the electronic device 50 when inserted in a package (not shown).

The electronic device 110 further comprises a covering layer or cap layer 112 which extends on the top side 69a of the passivation layer 69 and on the lateral portions 69c, up to reaching and contacting the top surface 53a of the semiconductor body 53 on the right side of the representation of Figure 8, and on the metallization 58 on the left side of the representation of Figure 8, forming respective coupling regions 114. In this manner, the coupling regions 114 provide respective physical coupling elements between the cap layer 112 and the underlying layers, laterally to the passivation layer 69, to bond or maintain the passivation layer 69 in position, thus obviating a possible detachment or delamination of the passivation layer 69.

The cap layer 112 does not extend at the regions dedicated to housing the scribe line.

The material of the cap layer 112 is configured to have predetermined characteristics of adhesion to the material to the passivation layer 69 and underlying layers at coupling regions 114 (here, layers 58 and 53").

Materials for the aforementioned purposes include aluminum oxide (or alumina) Al₂O₃ and hafnium oxide Hf₂O₃, in particular in case the passivation layer 69 is of a material from among polyimide, HfO₂, ZrO₂, TiO₂, Ta₂O₅, TiN, ZnO, AZO, GZO.

The Applicant has verified that a deposition by ALD (Atomic Layer Deposition) technique is effective in forming the cap layer 112 with characteristics of adhesion and protection suitable for the purposes of the present disclosure. The cap layer 112 has, for example, a thickness comprised between 8 nm and 100 nm, in particular between 10 nm and 50 nm.

In addition to the aforementioned characteristics of adhesion, the Applicant has verified that the cap layer 112 of Hf₂O₃ or Al₂O₃ possesses humidity barrier properties.

In a per se evident manner and therefore not further described, it is possible to implement, in the embodiment of Figure 8, the indentations 86 with the respective elements 84 described with reference to Figure 4 and/or the anchor element 88 described with reference to Figure 5.

The advantages that the present invention affords are evident.

In particular, the one or more adhesion improving layers described improve the adhesion of the passivation layer 69 to the rest of the device, preventing delamination phenomena. It is thus possible to form the passivation layer 69 in polymeric materials, ensuring high electrical performances of the electronic device 50, 100 (due to the high dielectric strength of the passivation layer 69) and eliminating, at the same time, structural problems linked to the possible detachment of the passivation layer 69 (e.g., following thermal or use cycles of the electronic device 50, 100).

Consequently, the risk of damaging the electronic device 50, 100 as a result of electric discharges between metallizations set at different potentials (e.g., between the EQR metallization and the anode metallization 58) is avoided, and therefore the reliability of the electronic device 50, 100 increases, in particular when subject to high thermal excursions and operated in reverse bias condition.

The manufacturing steps described allow manufacturing the electronic device 50 and, respectively, 100 comprising the respective adhesion improvement elements starting from a SiC wafer, without limitations resulting from the starting material (SiC).

Finally, it is clear that modifications and variations may be made to the invention described and illustrated herein without thereby departing from the scope of the present invention, as defined in the attached claims.

In particular, although the present invention has been described with explicit reference to SiC as the starting substrate material, the present invention also applies to devices based on substrates of other semiconductor materials, such as for example Silicon, GaN, etc.

## Claims

1. An electronic device (50), comprising:
a solid body (53, 58, 61) including an electrical terminal (58) of the electronic device on the solid body (53) ;
a passivation layer (69) on the electrical terminal (58), of a first material;
a first adhesion improving layer (82a) coupled to the passivation layer (69) and to the solid body (53), of a second material having predefined characteristics of adhesion to the first material, and configured to bond together the passivation layer (69) and the solid body (53),
wherein the first adhesion improving layer (82a) extends between the solid body (53, 58, 61) and the passivation layer (69), in direct contact with the passivation layer (69),
wherein the passivation layer (69) has a top surface (69a), a bottom surface (69b) facing the solid body and lateral surfaces (69c) which connect the top surface (69a) to the bottom surface (69b),
the electronic device (50) further comprising a second adhesion improving layer (82b) which extends continuously on the top surface (69a) of the passivation layer (69) and, at least in part, on the lateral surfaces (69c) of the passivation layer (69),
**characterized in that** the electronic device (50) further comprises one or more coupling structures (92, 94) passing through the passivation layer (69), physically coupled to the first adhesion improving layer (82a) and to the second adhesion improving layer (82b), wherein said one or more coupling structures (92, 94) are columns of the same material as the second adhesion improving layer (82b).

2. The electronic device according to claim 1, wherein said one or more coupling structures (92, 94) are coupled to respective portions of the first and the second adhesion improving layer (82a, 82b) extending on the electrical terminal (58).

3. The electronic device according to claim 1 or claim 2, wherein the first material comprises polymeric material and the second material is one of Al₂O₃ and Hf₂O₃.

4. The electronic device according to anyone of the preceding claims, wherein the second adhesion improving layer (82b) extends continuously on the top surface (69a) of the passivation layer (69), on the lateral surfaces (69c) of the passivation layer (69) and on the solid body (53, 58, 61) laterally to said lateral surfaces (69c) of the passivation layer (69).

5. The electronic device according to anyone of claims 1-3, wherein the second adhesion improving layer (82b) is absent on the solid body (53, 58, 61) laterally to said lateral surfaces (69c) of the passivation layer (69).

6. The electronic device according to anyone of the preceding claims, wherein the first and the second adhesion improving layers (82a, 82b) are of a same material or of different materials, from among Al₂O₃ and Hf₂O₃.

7. The electronic device according to anyone of the preceding claims, chosen from the group comprising: a Schottky diode, a PiN diode, a PN diode, an MPS device, a JBS diode, a MOSFET, an IGBT, a power device.

8. A method for manufacturing an electronic device (50), comprising the steps of:
providing a solid body (53, 58, 61) including an electrical terminal (58) of the electronic device on the solid body (53);
forming a passivation layer (69), of a first material, on the electrical terminal (58);
coupling a first adhesion improving layer (82a) to the passivation layer (69) and to the solid body (53), wherein the first adhesion improving layer (82a) is of a second material having predefined characteristics of adhesion to the first material, and is configured to bond together the passivation layer (69) and the solid body (53),
wherein the first adhesion improving layer (82a) is formed on the solid body (53, 58, 61) before the step of forming the passivation layer (69),
said passivation layer being formed in direct contact with the first adhesion improving layer,
wherein the passivation layer (69) has a top surface (69a), a bottom surface (69b) facing the solid body and lateral surfaces (69c) which connect the top surface (69a) to the bottom surface (69b),
the method further comprising the step of forming a second adhesion improving layer (82b) which extends continuously on the top surface (69a) of the passivation layer (69) and at least in part on the lateral surfaces (69c) of the passivation layer (69),
the method being **characterized by** further comprising the step of forming one or more coupling structures (92, 94) passing through the passivation layer (69), physically coupled to the first adhesion improving layer (82a) and to the second adhesion improving layer (82b), wherein said one or more coupling structures (92, 94) are columns of the same material as the second adhesion improving layer (82b).

9. The method according to claim 8, wherein the first adhesion improving layer (82; 102; 112) is of a material chosen from among Al₂O₃ and Hf₂O₃.

10. The method according to claim 8 or claim 9, wherein the first adhesion improving layer (82a) extends continuously on the top surface (69a) of the passivation layer (69), on the lateral surfaces (69c) of the passivation layer (69) and on the solid body (53, 58, 61) laterally to said lateral surfaces (69c) of the passivation layer (69).

11. The method according to anyone of claims 8-10, wherein the first and the second adhesion improving layers (82a, 82b) are of a same material or of different materials, from among Al₂O₃and Hf₂O₃.

12. The method according to anyone of claims 8-11, wherein the material of the passivation layer (69) comprises polymeric material.

13. The method according to anyone of claims 8-12, wherein the step of forming said one or more coupling structures (92, 94) is performed simultaneously with the step of forming the second adhesion improving layer (82b) and comprises a CVD or ALD deposition step.
